# EUROPÄISCHE PATENTSCHRIFT

(11) **EP 3 679 650 B1**
(45) Veröffentlichungstag und Bekanntmachung des Hinweises auf die Patenterteilung: **17.05.2023**
(21) Anmeldenummer: 18778397.2
(22) Anmeldetag: 14.09.2018
(51) Int. Cl.: H03G 3/30

(54) **VERFAHREN UND VORRICHTUNG ZUR DURCHFÜHRUNG EINES MORPHING-PROZESSES VON AUDIOSIGNALEN**
METHOD AND APPARATUS FOR CARRYING OUT A MORPHING PROCESS OF AUDIO SIGNALS
MÉTHODE ET APPAREIL POUR RÉALISER L' EXÉCUTION D'UNE MORPHOSE DE SIGNAUX AUDIO

(30) Priorität: 16.10.2017 DE 102017124046
(43) Veröffentlichungstag der Anmeldung: 15.07.2020
(73) Patentinhaber: ASK Industries GmbH, 94559 Niederwinkling (DE)
(72) Erfinder: KALINICHENKO, Victor, 94234 Viechtach (DE)
(74) Vertreter: Hafner & Kohl PartmbB
(86) Internationale Anmeldenummer: PCT/EP2018/074981
(87) Internationale Veröffentlichungsnummer: WO 2019/076554

(56) Entgegenhaltungen:
- WO-A2-03/009469
- DE-A1-102008 023 919
- US-A1- 2011 103 593

## Beschreibung

Die Erfindung betrifft ein Verfahren und eine Vorrichtung zur Durchführung eines Morphingvorgangs, wobei wenigstens ein die Ausgabe eines über eine Audioausgabeeinrichtung in einen Innenraum, insbesondere eines Kraftfahrzeugs, ausgegebenen Audiosignals betreffender Ausgabeparameter verändert wird.

Die Patentanmeldung US 2011103593 A1 aus dem Stand der Technik, die sich auf das technische Gebiet der Erfindung bezieht, wird mit zitiert, in der ein Verfahren zur Verarbeitung von Audiosignalen basierend auf Zeitmultiplexing offenbart wird.

Morphingvorgänge bzw. entsprechende Verfahren zur Durchführung von Morphingvorgängen sind dem Grunde nach bekannt. Bei entsprechenden Morphingvorgängen wird bzw. werden ein oder mehrere die Ausgabe eines Audiosignals über eine akustische Audioausgabeeinrichtung betreffende(r) Ausgabeparameter gezielt verändert.

Entsprechende Morphingvorgänge werden z. B. durchgeführt, wenn eine durch entsprechende Ausgabeparameter definierte Ausgabeeinstellung einer Audioausgabeeinrichtung verändert wird. Beispielhaft wird im Zusammenhang mit einer akustischen Audioausgabeeinrichtung eines Kraftfahrzeugs auf eine Änderung der Position des "Sweetspots", d. h. des Bereichs des Innenraums des Kraftfahrzeugs, in welchem das ausgegebene Audiosignal (möglichst) optimal wahrnehmbar ist, verwiesen. Eine entsprechende Änderung der Position des "Sweetspots" kann z. B. erfolgen, wenn ein fahreroptimierter Ausgabemodus in einen nicht-fahreroptimierten, d. h. z. B. einen beifahreroptimierten, Ausgabemodus, mithin der "Sweetspot" von einer fahrerorientierten Ausrichtung auf eine nicht-fahrerorientierte, d. h. z. B. eine beifahrerorientierte, Ausrichtung, oder umgekehrt, geändert wird.

Die Realisierung entsprechender Morphingvorgänge erfolgt über mit geeigneten Morphingalgorithmen ausgestattete hard- und/oder softwaremäßig implementierte, typischerweise eine Rechenprozessoreinrichtung und eine Datenspeichereinrichtung umfassende Morphingeinrichtungen. Entsprechende Morphingeinrichtungen stellen typischerweise hard- und/oder softwaremäßig implementierte Bestandteile entsprechender Audioausgabeeinrichtungen dar.

Bekannte Morphingeinrichtungen erfordern im Rahmen der Durchführung von Morphingvorgängen typischerweise eine vergleichsweise hohe Rechenprozessorleistung und einen vergleichsweise hohen Speicherbedarf. Die bekannten Morphingeinrichtungen sind sonach im Hinblick auf eine effiziente Nutzung der Rechenprozessorleistung bzw. des Speicherbedarfs verbesserungswürdig.

Der Erfindung liegt die Aufgabe zugrunde, ein, insbesondere im Hinblick auf eine Möglichkeit einer effizienten Nutzung der Rechenprozessorleistung bzw. des Speicherbedarfs, verbessertes Verfahren zur Durchführung eines Morphingvorgangs anzugeben.

Die Aufgabe wird durch ein Verfahren zur Durchführung eines Morphingvorgangs gemäß Anspruch 1 gelöst. Die hierzu abhängigen Ansprüche betreffen vorteilhafte Ausführungsformen des Verfahrens. Die Aufgabe wird ferner durch eine Vorrichtung gemäß Anspruch 11 gelöst.

Das hierin beschriebene Verfahren dient im Allgemeinen der Durchführung eines Morphingvorgangs. Bei einem entsprechenden Morphingvorgang wird wenigstens ein die Ausgabe eines über eine Audioausgabeeinrichtung in einen Innenraum ausgegebenen Audiosignals betreffender Ausgabeparameter verändert. Durch entsprechende Ausgabeparameter werden typischerweise Ausgabeeinstellungen der Audioausgabeeinrichtung definiert, sodass im Rahmen der Durchführung eines Morphingvorgangs typischerweise auch entsprechende Ausgabeeinstellungen der Audioausgabeeinrichtung geändert werden. Mithin kann im Rahmen der Durchführung eines Morphingvorgangs eine durch wenigstens einen ersten Ausgabeparameter definierte erste Ausgabeeinstellung einer Audioausgabeeinrichtung in eine durch wenigstens einen von dem ersten Ausgabeparameter unterschiedlichen zweiten Ausgabeparameter definierte zweite Ausgabeeinstellung der Audioausgabeeinrichtung geändert werden. Die Durchführung entsprechender Morphingvorgänge soll in allen Fällen für einen Hörer nicht bzw. kaum wahrnehmbar sein.

Ein konkretes Beispiel für die durch einen Morphingvorgang erfolgende Änderung entsprechender Ausgabeeinstellungen ist eine Änderung einer durch wenigstens einen ersten Ausgabeparameter definierten ersten Ausgabeeinstellung, welche ein räumliches Hörerlebnis ermöglicht ("3D-Sound" bzw. "3D-Surround"), in eine durch wenigstens einen zweiten Ausgabeparameter definierte zweite Ausgabeeinstellung, welche - ähnlich dem tatsächlichen Besuch eines Konzerts - ein besonders intensives Hörerlebnis ermöglicht ("Live-Sound" bzw. "Live-Surround"). Ein weiteres konkretes Beispiel für die durch einen Morphingvorgang erfolgende Änderung entsprechender Ausgabeeinstellungen ist eine Änderung der Position des "Sweetspots", d. h. des Bereichs des Innenraums, insbesondere eines Kraftfahrzeugs, in welchem das ausgegebene Audiosignal (möglichst) optimal wahrnehmbar ist, verwiesen. Eine entsprechende Änderung der Position des "Sweetspots" kann für eine beispielhafte Anwendung eines Morphingvorgangs im Bereich der Kraftfahrzeugtechnik z. B. erfolgen, wenn ein fahreroptimierter Ausgabemodus in einen nicht-fahreroptimierten, d. h. z. B. einen beifahreroptimierten, Ausgabemodus, mithin der "Sweetspot" von einer fahrerorientierten Ausrichtung auf eine nicht-fahrerorientierte, d. h. z. B. eine beifahrerorientierte, Ausrichtung, oder umgekehrt, geändert wird. Selbstverständlich sind neben den genannten Beispielen andere durch einen Morphingvorgang erfolgende Änderungen entsprechender Ausgabeeinstellungen denkbar.

Bei einer entsprechenden Audioausgabeeinrichtung kann es sich konkret z. B. um eine Multikanalaudioausgabeeinrichtung, d. h. um eine Audioausgabeeinrichtung, welche über mehrere, d. h. wenigstens zwei, akustische Audioausgabeelemente bzw. -kanäle verfügt, handeln. Das über die Audioausgabeeinrichtung ausgebbare bzw. ausgegebene Audiosignal, welches z. B. ein Musikstück beschreibt, wird über eine Audiosignalquelleinrichtung ("Signalquelle") bereitgestellt; hierbei kann es sich um jedwede der Audioausgabeeinrichtung zuordenbare bzw. zugeordnete Daten- oder Tonträgereinrichtung, d. h. z. B. ein Tonträgerabspielgerät (CD-Spieler, Plattenspieler, etc.), ein (mobiles) Endgerät (Smartphone, Tablet-PC, Laptop, etc.), eine Festplatte, eine Speicherkarte, eine CD, eine Netzwerkeinrichtung (Internet-Radio, Streaming-Dienste, etc.), etc., handeln.

Die Audioausgabeeinrichtung kann in einem Kraftfahrzeug installierbar bzw. installiert sein, um Audiosignale in einen Innenraum des Kraftfahrzeugs, d. h. insbesondere in die Fahrgastzelle bzw. in wenigstens einen bestimmten Bereich der Fahrgastzelle, auszugeben. Alternativ kann die Audioausgabeeinrichtung, z. B. als Bestandteil einer Multimediaeinrichtung ("Home Theater"), in einem Innenraum eines Gebäudes installierbar bzw. installiert sein, um Audiosignale in einen Innenraum des Gebäudes bzw. in wenigstens einen bestimmten Bereich des Innenraums des Gebäudes auszugeben. Weiter alternativ kann die Audioausgabeeinrichtung auch in einem mobilen Endgerät installierbar bzw. installiert sein, um Audiosignale in einen Innenraum bzw. in wenigstens einen bestimmten Bereich eines Innenraums auszugeben. Die vorgenannten Ausführungen zu der Ausgabe von Audiosignalen in einen Innenraum lassen sich selbstverständlich auch auf die Ausgabe von Audiosignalen in einen Außenraum bzw. in wenigstens einen bestimmten Bereich eines Außenraums übertragen.

Die Implementierung des Verfahrens, d. h. die verfahrensgemäße Durchführung entsprechender Morphingvorgänge, erfolgt über eine mit geeigneten Morphingalgorithmen ausgestattete hard- und/oder softwaremäßig implementierte Morphingeinrichtung als hard- und/oder softwaremäßigem Bestandteil der Audioausgabeeinrichtung. Die Morphingeinrichtung umfasst typischerweise eine Rechenprozessoreinrichtung ("Prozessor") und eine Datenspeichereinrichtung ("Speicher").

Die verfahrensgemäß abfolgenden Schritte des hierin beschriebenen Verfahrens werden im Weiteren näher erläutert:
In einem ersten Schritt erfolgt ein Zuführen eines von einer Audiosignalquelleinrichtung bereitgestellten Audiosignals zu einer Audiomischeinrichtung über eine mehrere FIR-Koeffizienten (Filterkoeffizienten) umfassende FIR-Filtereinrichtung. Mithin wird in dem ersten Schritt ein von einer Audiosignalquelleinrichtung bereitgestelltes Audiosignal über eine einen mehrere FIR-Koeffizienten umfassenden FIR-Algorithmus umfassende FIR-Filtereinrichtung (FIR-Filter), d. h. eine aus der digitalen Signalverarbeitung an sich bekannte Filtereinrichtung mit einem Filter endlicher Impulsantwort, zu einer Audiomischeinrichtung, d. h. einer an sich bekannten Audiomischeinrichtung zur Mischung von Audiosignalen, zugeführt. Das Audiosignal wird der Audiomischeinrichtung in dem ersten Schritt zu 100%, mithin ausschließlich bzw. vollständig, über die FIR-Filtereinrichtung zugeführt.

In einem auf den ersten Schritt folgenden zweiten Schritt erfolgt ein Anwenden einer ersten Übergangsfunktion, gemäß welcher das Zuführen des Audiosignals über die FIR-Filtereinrichtung sukzessive von 100% auf 0% verringert wird und das Zuführen des Audiosignals über eine der FIR-Filtereinrichtung parallel geschaltete Signalverarbeitungseinrichtung im Gegenzug sukzessive von 0% auf 100% erhöht wird. Mithin wird in dem zweiten Schritt eine erste Übergangsfunktion bzw. -vorschrift angewendet, gemäß welcher das Zuführen des Audiosignals zu der Audiomischeinrichtung über die FIR-Filtereinrichtung sukzessive von 100% auf 0% verringert und im Gegenzug das Zuführen des Audiosignals zu der Audiomischeinrichtung über eine der FIR-Filtereinrichtung parallel geschaltete Signalverarbeitungseinrichtung sukzessive von 0% auf 100% erhöht wird. Zu Beginn des zweiten Schritts wird das Audiosignal der Audiomischeinrichtung sonach zu 100% über die FIR-Filtereinrichtung zugeführt, zum Ende des zweiten Schritts wird das Audiosignal der Audiomischeinrichtung sonach zu 100% über die der FIR-Filtereinrichtung parallel geschaltete Signalverarbeitungseinrichtung zugeführt. Zwischen Beginn und Ende des zweiten Schritts erfolgt eine Zuführung des Audiosignals zu bestimmten, zeitlich variierenden prozentualen Anteilen sowohl über die FIR-Filtereinrichtung als auch über die Signalverarbeitungseinrichtung. Die jeweiligen prozentualen Anteile bestimmen sich durch die durch die erste Übergangsfunktion definierte Maßgabe, dass das Zuführen des Audiosignals zu der Audiomischeinrichtung über die FIR-Filtereinrichtung sukzessive von 100% auf 0% verringert und im Gegenzug das Zuführen des Audiosignals zu der Audiomischeinrichtung über die Signalverarbeitungseinrichtung sukzessive von 0% auf 100% erhöht wird. Die Verringerung des Zuführens des Audiosignals zu der Audiomischeinrichtung über die FIR-Filtereinrichtung und die Erhöhung des Zuführens des Audiosignals zu der Audiomischeinrichtung über die Signalverarbeitungseinrichtung kann gegebenenfalls (zeitlich) parallel erfolgen.

Als erste Übergangsfunktion kann eine lineare oder eine nicht-lineare Funktion verwendet werden. Die Verringerung bzw. Erhöhung der Zuführung des Audiosignals über die FIR-Filtereinrichtung bzw. über die Signalverarbeitungseinrichtung kann sonach linear oder nicht-linear erfolgen.

Als zu der FIR-Filtereinrichtung parallel geschaltete Signalverarbeitungseinrichtung wird typischerweise eine Einrichtung verwendet, welche weniger Rechenleistung und/oder weniger Speicher als die FIR-Filtereinrichtung aufweist. Es sollte eine Einrichtung verwendet werden, welche im Rahmen der Durchführung eines Morphingvorgangs keine von einem Hörer gegebenenfalls als störend empfundenen akustischen Effekte bedingt. Konkret kann als Signalverarbeitungseinrichtung z. B. eine Verstärkungseinrichtung oder eine IIR-Filtereinrichtung, d. h. eine Filtereinrichtung mit unendlicher Impulsantwort, welche insbesondere einen oder mehrere biquadratische Abschnitte ("Biquads") umfasst, verwendet werden.

In einem auf den zweiten Schritt folgenden dritten Schritt erfolgt während des Zuführens des Audiosignals über die Signalverarbeitungseinrichtung ein Ändern, insbesondere Wechseln, wenigstens eines Teils der FIR-Koeffizienten der FIR-Filtereinrichtung. Mithin wird in dem dritten Schritt wenigstens ein Teil der FIR-Koeffizienten der FIR-Filtereinrichtung, d. h. gegebenenfalls alle FIR-Koeffizienten der FIR-Filtereinrichtung, geändert. Unter einer Änderung der FIR-Koeffizienten der FIR-Filtereinrichtung ist insbesondere eine Aktualisierung ("Update") der FIR-Koeffizienten der FIR-Filtereinrichtung zu verstehen. Die Änderung der FIR-Koeffizienten der FIR-Filtereinrichtung erfolgt währenddessen das Audiosignal der Audiomischeinrichtung über die Signalverarbeitungseinrichtung zugeführt wird. Die FIR-Koeffizienten der FIR-Filtereinrichtung werden sonach geändert, wenn das Audiosignal der Audiomischeinrichtung nicht über die FIR-Filtereinrichtung, sondern über die Signalverarbeitungseinrichtung zugeführt wird.

Das Ändern des wenigstens einen Teils der FIR-Koeffizienten kann durch Laden bzw. Neuladen von FIR-Koeffizienten aus einer Speichereinrichtung, insbesondere einer nicht-flüchtigen Datenspeichereinrichtung, d. h. z. B. einer Flash-Speichereinrichtung, oder durch Wechseln der FIR-Filterkoeffizienten, insbesondere eines mehrere oder sämtliche zu ändernden FIR-Koeffizienten umfassenden FIR-Koeffizientensatzes, durch zuvor in einer Speichereinrichtung, insbesondere einer nicht-flüchtigen Datenspeichereinrichtung, gespeicherte FIR-Filterkoeffizienten, insbesondere durch einen mehrere oder sämtliche zu ändernden FIR-Koeffizienten umfassenden FIR-Koeffizientensatz, erfolgen. Das Ändern des wenigstens einen Teils der FIR-Koeffizienten erfolgt typischerweise erst dann, wenn die erste Übergangsfunktion vollständig abgeschlossen ist, d. h. das Zuführen des Audiosignals zu der Audiomischeinrichtung vollständig über die Signalverarbeitungseinrichtung erfolgt. Derart kann die Gefahr der Entstehung unerwünschter akustischer Störsignale reduziert werden.

Während des Änderns des wenigstens einen Teils der FIR-Koeffizienten kann unter Umständen eine zeitweise Unterbrechung der (Echt-Zeit-)Verarbeitung des bereitgestellten Audiosignals erfolgen. Die Unterbrechung der (Echt-Zeit-)Verarbeitung des bereitgestellten Audiosignals erfolgt typischerweise nur in der FIR-Filtereinrichtung, nicht in der Signalverarbeitungseinrichtung. Die Unterbrechung der der (Echt-Zeit-)Verarbeitung des bereitgestellten Audiosignals führt sonach nicht zu einer (negativen) Beeinflussung der Wiedergabe des Audiosignals. Erfolgt eine entsprechende Unterbrechung der (Echt-Zeit-)Verarbeitung des bereitgestellten Audiosignals kann es gegebenenfalls ratsam sein, auch die Verzögerungsleitung ("delay line") der FIR-Filtereinrichtung zu leeren, um eine Reproduktion des Signals, welches in der Verzögerungsleitung vor der Unterbrechung der (Echt-Zeit-)Verarbeitung des bereitgestellten Audiosignals gespeichert wurde, zu vermeiden, nachdem die Unterbrechung der (Echt-Zeit-)Verarbeitung des bereitgestellten Audiosignals aufgehoben und die (Echt-Zeit-)Verarbeitung des bereitgestellten Audiosignals wiederaufgenommen wird.

In einem auf den dritten Schritt folgenden vierten Schritt erfolgt ein Anwenden einer zweiten Übergangsfunktion (Rückübergangsfunktion), gemäß welcher das Zuführen des Audiosignals über die Signalverarbeitungseinrichtung sukzessive von 100% auf 0% verringert wird und das Zuführen des Audiosignals über die FIR-Filtereinrichtung im Gegenzug sukzessive von 0% auf 100% erhöht wird, wobei das Zuführen des Audiosignals über die FIR-Filtereinrichtung (sodann) auf Grundlage der veränderten FIR-Koeffizienten der FIR-Filtereinrichtung durchgeführt wird. Mithin wird in dem vierten Schritt eine zweite, insbesondere zu der ersten Übergangsfunktion inverse, Übergangsfunktion bzw. -vorschrift angewendet, gemäß welcher das Zuführen des Audiosignals zu der Audiomischeinrichtung über die Signalverarbeitungseinrichtung (wieder) sukzessive von 100% auf 0% verringert und im Gegenzug das Zuführen des Audiosignals zu der Audiomischeinrichtung über die FIR-Filtereinrichtung (wieder) sukzessive von 0% auf 100% erhöht wird. Zu Beginn des vierten Schritts wird das Audiosignal der Audiomischeinrichtung sonach zu 100% über die Signalverarbeitungseinrichtung zugeführt, zum Ende des vierten Schritts wird das Audiosignal der Audiomischeinrichtung sonach (wieder) zu 100% über die FIR-Filtereinrichtung zugeführt. Zwischen Beginn und Ende des vierten Schritts erfolgt eine Zuführung des Audiosignals zu bestimmten, zeitlich variierenden prozentualen Anteilen sowohl über die Signalverarbeitungseinrichtung als auch über die FIR-Filtereinrichtung. Die jeweiligen prozentualen Anteile bestimmen sich durch die durch die zweite Übergangsfunktion definierte Maßgabe, dass das Zuführen des Audiosignals zu der Audiomischeinrichtung über die Signalverarbeitungseinrichtung sukzessive von 100% auf 0% verringert und im Gegenzug das Zuführen des Audiosignals zu der Audiomischeinrichtung über die FIR-Filtereinrichtung sukzessive von 0% auf 100% erhöht wird. Die Verringerung des Zuführens des Audiosignals zu der Audiomischeinrichtung über die Signalverarbeitungseinrichtung und die Erhöhung des Zuführens des Audiosignals zu der Audiomischeinrichtung über die FIR-Filtereinrichtung kann (zeitlich) parallel erfolgen.

Als zweite Übergangsfunktion kann eine lineare oder eine nicht-lineare Funktion verwendet werden. Die Verringerung bzw. Erhöhung der Zuführung des Audiosignals über die Signalverarbeitungseinrichtung bzw. über die FIR-Filtereinrichtung kann sonach linear oder nicht-linear erfolgen.

Das Verfahren ermöglicht eine effiziente Nutzung der Rechenprozessorleistung bzw. des Speicherbedarfs der Morphingeinrichtung. Dies ergibt sich insbesondere durch die beschriebene variierende Zuführung des Audiosignals zu der Audiomischeinrichtung über die FIR-Filtereinrichtung und die dieser parallel geschaltete Signalverarbeitungseinrichtung sowie durch die zwischenzeitlich, d.h. in dem dritten Schritt, erfolgende Änderung der FIR-Koeffizienten der FIR-Filtereinrichtung. Durch das Verfahren ist im Zusammenhang mit der Durchführung eines Morphingvorgangs durch die der FIR-Filtereinrichtung parallel geschaltete, mithin als "Bypass" zu erachtende Signalverarbeitungseinrichtung ein alternativer Signalweg um die FIR-Filtereinrichtung geschaffen.

Es ist denkbar, dass die im Rahmen des Anwendens der Rückübergangsfunktion, vgl. den vierten Schritt, angewendeten Parameter in Abhängigkeit von Eigenschaften der zu "morphenden" FIR-Filtereinrichtung erfolgt. Beispielsweise ist es möglich, dass die Antworteigenschaften, insbesondere die Magnitude-Response, der Signalverarbeitungseinrichtung, d. h. z. B. einer IIR-Filtereinrichtung, an die Antworteigenschaften, insbesondere die Magnitude-Response, der FIR-Filtereinrichtung, anpasst bzw. angleicht.

Das Verfahren kann auch mit mehreren parallel geschalteten FIR-Filtereinrichtungen und diesen jeweils zugeordneten Audiomischeinrichtungen angewendet werden. Dabei kann jeder FIR-Filtereinrichtung eine Audiomischeinrichtung zugeordnet werden, mithin jede FIR-Filtereinrichtung mit einer dieser zugeordneten Audiomischeinrichtung verbunden werden. Eine Signalverarbeitungseinrichtung ist zu allen FIR-Filtereinrichtungen parallel angeordnet und ebenso mit den den FIR-Filtereinrichtungen zugeordneten Audiomischeinrichtungen verbunden. Das Verfahren kann sonach auch mit einer (einzigen) Signalverarbeitungseinrichtung und mehreren FIR-Filtereinrichtungen angewendet werden; die verfahrensgemäß erfolgende Änderung der FIR-Koeffizienten der FIR-Filtereinrichtungen kann zeitgleich oder zeitlich gestaffelt erfolgen. Selbstverständlich kann das Verfahren, wie sich im Weiteren ergibt, auch mit einer (einzigen) FIR-Filtereinrichtung und mehreren Signalverarbeitungseinrichtungen angewendet werden.

Sofern das Verfahren mit mehreren parallel geschalteten FIR-Filtereinrichtungen und diesen jeweils zugeordneten Audiomischeinrichtungen angewendet wird, kann eine der Signalverarbeitungseinrichtung vorgeschaltete weitere Audiomischeinrichtung verwendet werden, über welche während der Durchführung des Verfahrens mit einer bestimmten FIR-Filtereinrichtung den übrigen FIR-Filtereinrichtungen zugeordnete Audiosignale zugemischt werden können, sodass ein Hörer den (aktuell durchgeführten) Morphingvorgang nicht bzw. kaum wahrnimmt.

Verfahrensgemäß kann die Energie, d. h. insbesondere die Lautstärke, des von der Audiomischeinrichtung während oder nach Durchführung des Morphingvorgangs ausgehenden Audiosignals im Rahmen der Anwendung der ersten Übergangsfunktion von der Energie des von der FIR-Filtereinrichtung ausgehenden Audiosignals auf die Energie des von der Signalverarbeitungseinrichtung ausgehenden Audiosignals verändert werden. Derart ist eine Maßnahme gegeben, welche es ermöglicht, dass der Morphingvorgang für einen Hörer nicht bzw. kaum wahrnehmbar ist.

Verfahrensgemäß kann die zweite Übergangsfunktion erst nach einer bestimmten Wartezeit bzw. Zeitdauer, d. h. z. B. eine Sekunde, nach Abschluss der Anwendung der ersten Übergangsfunktion, d. h. erst, wenn die erste Übergangsfunktion vollständig abgeschlossen ist, durchgeführt werden. Auch derart ist eine Maßnahme gegeben, welche es ermöglicht, dass der Morphingvorgang für einen Hörer durch unerwünschte Störsignale nicht bzw. kaum wahrnehmbar ist. Die Wartezeit, nach welcher die zweite Übergangsfunktion angewendet wird, kann auf Grundlage der Länge der FIR-Filtereinrichtung bestimmt und somit auf die durch die Länge der FIR-Filtereinrichtung bzw. der FIR-Koeffizienten gegebene "Konfiguration" der FIR-Filtereinrichtung abgestimmt werden. Die Wartezeit ist typischerweise nicht kürzer als die Länge der FIR-Filtereinrichtung.

Verfahrensgemäß können eine Mehrzahl an unterschiedlichen Signalverarbeitungseinrichtungen zur Verfügung stehen, wobei die Auswahl, welche Signalverarbeitungseinrichtung im Rahmen des Anwendens der ersten und zweiten Übergangsfunktion verwendet wird, auf Grundlage wenigstens eines die akustischen Eigenschaften des Audiosignals beschreibenden Audiosignalparameters, insbesondere des Frequenzverlaufs des Audiosignals, erfolgen kann. Die Ermittlung entsprechenden Audiosignalparameter, welche der Auswahl einer bestimmten Signalverarbeitungseinrichtung zugrunde gelegt wird, kann vermittels geeigneter Audiosignalanalyseparameter erfolgen. Die Auswahl, welche Signalverarbeitungseinrichtung im Rahmen des Anwendens der ersten und zweiten Übergangsfunktion verwendet wird, kann auch auf Grundlage des jeweiligen Energiepegels bzw. psychoakustischen Pegels respektive Amplituden- bzw. Frequenzbereichs der zur Auswahl stehenden Signalverarbeitungseinrichtungen erfolgen; wobei die Auswahl einer Signalverarbeitungseinrichtung mit einem im Vergleich zu der FIR-Filtereinrichtung (möglichst) ähnlichen Pegel respektive Amplituden- bzw. Frequenzbereich zweckmäßig ist.

Die gleichzeitige bzw. simultane Durchführung von Morphingvorgängen mehrerer FIR-Filtereinrichtungen kann unter bestimmten Bedingungen über eine (einzige) Signalverarbeitungseinrichtung erfolgen. In diesem Fall können gewichtete Inputs der FIR-Filtereinrichtungen der bzw. einer der Signalverarbeitungseinrichtung vorgeschalteten Audiomischeinrichtung und weiter der Signalverarbeitungseinrichtung zugeführt werden. Der Ausgang der Signalverarbeitungseinrichtung ist mit der Signalverarbeitungseinrichtung nachgeschalteten Audiomischeinrichtungen verbunden, der Ausgang der Signalverarbeitungseinrichtung kann demnach der Signalverarbeitungseinrichtung nachgeschalteten Audiomischeinrichtungen zugeführt, d. h. insbesondere auf der Signalverarbeitungseinrichtung nachgeschaltete Audiomischeinrichtungen verteilt, werden.

Wie weiter oben erwähnt, kann verfahrensgemäß als Signalverarbeitungseinrichtung z. B. eine Verstärkungseinrichtung oder eine IIR-Filtereinrichtung verwendet werden. Die Auswahl dahin, ob eine Verstärkungseinrichtung oder eine IIR-Filtereinrichtung als Signalverarbeitungseinrichtung verwendet wird, kann in Abhängigkeit der Bandweite (Frequenzbandweite) des Audiosignals erfolgen. Insbesondere kann bei Audiosignalen mit einer oberhalb einer Grenzbandweite, beispielsweise in einem Bereich zwischen 20 und 100 Hz oder höher, liegenden Bandweite eine Verstärkungseinrichtung als Signalverarbeitungseinrichtung verwendet werden und bei Audiosignalen mit einer unterhalb einer Grenzbandweite, beispielsweise in einem Bereich zwischen 20 und 100 Hz oder höher, liegenden Bandweite eine IIR-Filtereinrichtung als Signalverarbeitungseinrichtung verwendet werden. Die Auswahl dahin, welche Signalverarbeitungseinrichtung verwendet wird, kann auch unter Berücksichtigung des Zustands der FIR-Filtereinrichtung vor und/oder nach dem Morphingvorgang erfolgen.

Sofern eine Verstärkungseinrichtung als Signalverarbeitungseinrichtung verwendet wird, kann die Leistung, insbesondere der Gain, der Verstärkungseinrichtung auf einen Wert, welcher z. B. (im Wesentlichen) der L2-Norm der Impulsantwort der FIR-Filtereinrichtung entspricht, gesetzt werden, oder die Leistung, insbesondere der Gain, auf einen Wert, welcher einem Mittelwert der Impulsantwort der FIR-Filtereinrichtung vor der Änderung der FIR-Koeffizienten der FIR-Filtereinrichtung entspricht oder einem Mittelwert der Impulsantwort der FIR-Filtereinrichtung nach der Änderung der FIR-Koeffizienten entspricht, gesetzt werden. Derart kann der Leistungsbedarf der Verstärkungseinrichtung eingeschränkt und die Effizienz des Verfahrens verbessert werden.

Neben dem Verfahren betrifft die Erfindung eine Vorrichtung zur Durchführung eines Morphingvorgangs. Die Vorrichtung zeichnet sich durch eine einen mehrere FIR-Koeffizienten umfassenden FIR-Algorithmus umfassende FIR-Filtereinrichtung, wenigstens eine parallel zu dieser geschaltete Signalverarbeitungseinrichtung, beispielsweise eine Verstärkereinrichtung oder eine IIR-Filtereinrichtung, wenigstens eine Audiomischeinrichtung, welche mit jeweiligen Ausgängen der FIR-Filtereinrichtung und der Signalverarbeitungseinrichtung verbunden ist, sowie eine Morphingeinrichtung, welche zur Steuerung eines Morphingvorgangs gemäß dem beschriebenen Verfahren eingerichtet ist, aus. Sämtliche Ausführungen im Zusammenhang mit dem Verfahren gelten analog für die Vorrichtung.

Die Vorrichtung kann als zur Durchführung eines Morphingvorgangs zusammenwirkende Funktionskomponenten folgende, jeweils hard- und/oder softwaremäßig implementierte Einrichtungen umfassen:
- wenigstens eine wenigstens ein akustisches Audioausgabeelement, d. h. z. B. ein Lautsprecherelement, umfassende akustische Audioausgabeeinrichtung, welche zur Ausgabe von Audiosignalen in einen Innenraum eingerichtet ist,
- wenigstens eine Audiomischeinrichtung,
- eine zwischen die Audiosignalquelleinrichtung und die Audiomischeinrichtung geschaltete FIR-Filtereinrichtung, welche eine Datenspeichereinrichtung, in welcher ein FIR-Algorithmus mit einer bestimmten Anzahl an FIR-Koeffizienten hinterlegt ist, umfasst,
- wenigstens eine parallel zu der FIR-Filtereinrichtung geschaltete Signalverarbeitungseinrichtung, d. h. im Allgemeinen eine Einrichtung, welche weniger Rechenleistung und/oder weniger Speicher als die FIR-Filtereinrichtung aufweist, im Besonderen eine Verstärkungseinrichtung oder eine IIR-Filtereinrichtung,
- eine Morphingeinrichtung, welche zur Durchführung eines vermittels der Vorrichtung durchgeführten verfahrensgemäßen Morphingvorgangs eingerichtet ist.

Die Vorrichtung kann in verschiedenen Audioausgabeeinrichtungen eingesetzt werden; lediglich beispielhaft ist auf den Bereich der Multimediaausgabeeinrichtungen für den Heimtechnikbereich ("Home Theater") oder Kraftfahrzeugtechnikbereich zu verweisen.

Insofern betrifft die Erfindung auch ein Kraftfahrzeug mit einer entsprechenden Vorrichtung zur Durchführung von Morphingvorgängen. Sämtliche Ausführungen im Zusammenhang mit der Vorrichtung sowie dem Verfahren gelten analog für das Kraftfahrzeug.

Die Erfindung ist anhand von Ausführungsbeispielen in den Fig. nochmals erläutert. Dabei zeigt:
- Fig. 1, 2: je eine Prinzipdarstellung einer Vorrichtung zur Durchführung eines Morphingvorgangs gemäß einem Ausführungsbeispiel; und
- Fig. 3, 4: je eine Prinzipdarstellung von im Rahmen eines Verfahrens gemäß einem Ausführungsbeispiel anwendbarer Übergangsfunktionen.

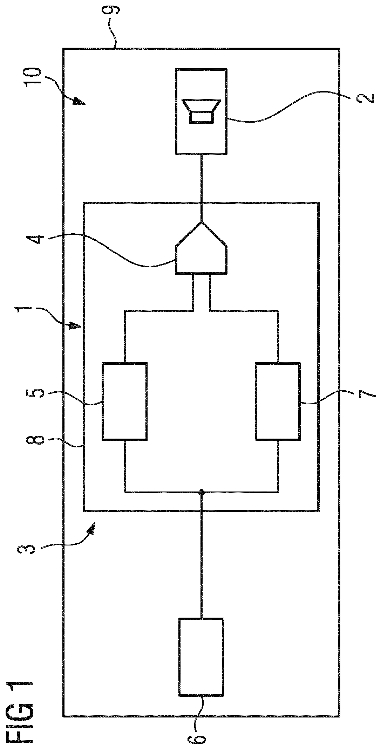

Fig. 1 zeigt eine Prinzipdarstellung einer Vorrichtung 1 zur Durchführung eines Morphingvorgangs gemäß einem ersten Ausführungsbeispiel der Erfindung. Bei einem Morphingvorgang wird wenigstens ein die Ausgabe eines über eine Audioausgabeeinrichtung 3 ausgegebenen Audiosignals betreffender Ausgabeparameter verändert. Durch entsprechende Ausgabeparameter werden Ausgabeeinstellungen der Audioausgabeeinrichtung 3 definiert, sodass im Rahmen der Durchführung eines Morphingvorgangs auch entsprechende Ausgabeeinstellungen der Audioausgabeeinrichtung 3 geändert werden.

Die Vorrichtung 1 kann an oder in einem einen Innenraum 10 aufweisenden Gegenstand 9 installiert sein. Bei dem Gegenstand 9 kann es sich z. B. um ein Kraftfahrzeug, bei dem Innenraum 10 entsprechend um eine Fahrgastzelle des Kraftfahrzeugs handeln. Denkbar wäre es jedoch auch, die Vorrichtung 1 in einem anderen Gegenstand 9, d. h. z. B. in einer Multimediaeinrichtung ("Home Theater"), zu installieren.

Die Vorrichtung 1 umfasst verschiedene zur Durchführung eines Morphingvorgangs zusammenwirkende Funktionskomponenten, welche jeweils hard- und/oder softwaremäßig implementierte Einrichtungen umfassen:
Die Vorrichtung 1 umfasst als eine entsprechende Funktionskomponente eine wenigstens ein akustisches Audioausgabeelement 2, d. h. z. B. ein Lautsprecherelement, umfassende Audioausgabeeinrichtung 3, welche zur Ausgabe von Audiosignalen, z. B. in den Innenraum 10, eingerichtet ist. Bei der Audioausgabeeinrichtung 3 kann es sich um eine Multikanalaudioausgabeeinrichtung, welche über mehrere, d. h. wenigstens zwei, akustische Audioausgabeelemente 2 verfügt, handeln.

Als weitere Funktionskomponente umfasst die Vorrichtung 1 eine dem Audioausgabeelement 2 vorgeschaltete Audiomischeinrichtung 4.

Als weitere Funktionskomponente umfasst die Vorrichtung 1 eine zwischen einen Audiosignalquelleinrichtung 6 und die Audiomischeinrichtung 4 geschaltete FIR-Filtereinrichtung 5. Die FIR-Filtereinrichtung 5 umfasst eine Datenspeichereinrichtung (nicht bezeichnet), in welcher ein FIR-Algorithmus mit einer bestimmten Anzahl an FIR-Koeffizienten hinterlegt ist.

Als weitere Funktionskomponente umfasst die Vorrichtung 1 eine parallel zu der FIR-Filtereinrichtung 5 geschaltete Signalverarbeitungseinrichtung 7. Bei der Signalverarbeitungseinrichtung 7 handelt es sich im Allgemeinen um eine Einrichtung, welche weniger Rechenleistung und/oder weniger Speicher als die FIR-Filtereinrichtung 5 aufweist. Beispielsweise kann es sich bei der Signalverarbeitungseinrichtung 7 um eine Verstärkereinrichtung oder um eine IIR-Filtereinrichtung handeln.

Die Audiomischeinrichtung 4, die FIR-Filtereinrichtung 5 und die Signalverarbeitungseinrichtung 7 können eine Morphingeinrichtung 8 der Vorrichtung 1 bilden.

Ein vermittels der Vorrichtung 1 durchgeführter Morphingvorgang erfolgt gemäß dem nachfolgend beschriebenen Verfahren zur Durchführung eines Morphingvorgangs:
In einem ersten Schritt des Verfahrens erfolgt ein Zuführen eines von der Audiosignalquelleinrichtung 6 bereitgestellten Audiosignals, d. h. z. B. einem Musikstück, zu der Audiomischeinrichtung 4 über die mehrere FIR-Koeffizienten (Filterkoeffizienten) umfassende FIR-Filtereinrichtung 5. Mithin wird in dem ersten Schritt ein von der Audiosignalquelleinrichtung 6 bereitgestelltes Audiosignal über die FIR-Filtereinrichtung 5 der Audiomischeinrichtung 4 zugeführt. Das von der Audiosignalquelleinrichtung 6 bereitgestellte Audiosignal wird der Audiomischeinrichtung 4 in dem ersten Schritt zu 100%, mithin ausschließlich bzw. vollständig, über die FIR-Filtereinrichtung 5 zugeführt.

In einem zweiten Schritt des Verfahrens erfolgt ein Anwenden einer ersten Übergangsfunktion, gemäß welcher das Zuführen des Audiosignals über die FIR-Filtereinrichtung 5 sukzessive von 100% auf 0% verringert wird und das Zuführen des Audiosignals über die der FIR-Filtereinrichtung 5 parallel geschaltete Signalverarbeitungseinrichtung 7 im Gegenzug sukzessive von 0% auf 100% erhöht wird. Zu Beginn des zweiten Schritts wird das Audiosignal der Audiomischeinrichtung 4 sonach zu 100% über die FIR-Filtereinrichtung 5 zugeführt, zum Ende des zweiten Schritts wird das Audiosignal der Audiomischeinrichtung 4 sonach zu 100% über die Signalverarbeitungseinrichtung 7 zugeführt. Zwischen Beginn und Ende des zweiten Schritts erfolgt eine Zuführung des Audiosignals zu bestimmten, zeitlich variierenden prozentualen Anteilen sowohl über die FIR-Filtereinrichtung 5 als auch über die Signalverarbeitungseinrichtung 7. Die jeweiligen prozentualen Anteile bestimmen sich durch die durch die erste Übergangsfunktion definierte Maßgabe, dass das Zuführen des Audiosignals zu der Audiomischeinrichtung 4 über die FIR-Filtereinrichtung 5 sukzessive von 100% auf 0% verringert und im Gegenzug das Zuführen des Audiosignals zu der Audiomischeinrichtung 4 über die Signalverarbeitungseinrichtung 7 sukzessive von 0% auf 100% erhöht wird. Als erste Übergangsfunktion kann eine lineare oder eine nicht-lineare Funktion verwendet werden. Die Verringerung bzw. Erhöhung der Zuführung des Audiosignals über die FIR-Filtereinrichtung 5 bzw. über die Signalverarbeitungseinrichtung 7 kann sonach linear oder nicht-linear erfolgen.

In einem dritten Schritt des Verfahrens erfolgt während des Zuführens des Audiosignals über die Signalverarbeitungseinrichtung 7 ein Ändern, insbesondere Wechseln, wenigstens eines Teils der FIR-Koeffizienten der FIR-Filtereinrichtung 5. Die Änderung der FIR-Koeffizienten der FIR-Filtereinrichtung 5 erfolgt währenddessen das Audiosignal der Audiomischeinrichtung 4 über die Signalverarbeitungseinrichtung 7 zugeführt wird. Die FIR-Koeffizienten der FIR-Filtereinrichtung 5 werden sonach geändert, wenn das Audiosignal der Audiomischeinrichtung 4 nicht über die FIR-Filtereinrichtung 5, sondern über die Signalverarbeitungseinrichtung 7 zugeführt wird.

Das Ändern des wenigstens einen Teils der FIR-Koeffizienten kann durch Laden bzw. Neuladen von FIR-Koeffizienten aus einer Speichereinrichtung (nicht gezeigt), insbesondere einer nicht-flüchtigen Datenspeichereinrichtung, d. h. z. B. einer Flash-Speichereinrichtung, oder durch Wechseln der FIR-Filterkoeffizienten, insbesondere eines mehrere oder sämtliche zu ändernden FIR-Koeffizienten umfassenden FIR-Koeffizientensatzes, durch zuvor in einer Speichereinrichtung, insbesondere einer nicht-flüchtigen Datenspeichereinrichtung, gespeicherte FIR-Filterkoeffizienten, insbesondere durch einen mehrere oder sämtliche zu ändernden FIR-Koeffizienten umfassenden FIR-Koeffizientensatz, erfolgen. Das Ändern der FIR-Koeffizienten erfolgt typischerweise erst dann, wenn die erste Übergangsfunktion vollständig abgeschlossen ist, d. h. das Zuführen des Audiosignals zu der Audiomischeinrichtung 4 vollständig über die Signalverarbeitungseinrichtung 7 erfolgt.

Während des Änderns des wenigstens einen Teils der FIR-Koeffizienten kann unter Umständen eine zeitweise Unterbrechung der (Echt-Zeit-)Verarbeitung des bereitgestellten Audiosignals erfolgen. Die Unterbrechung der (Echt-Zeit-)Verarbeitung des bereitgestellten Audiosignals, sofern erfolgend, erfolgt typischerweise nur in der FIR-Filtereinrichtung 5, nicht in der Signalverarbeitungseinrichtung 7. Erfolgt eine entsprechende Unterbrechung der (Echt-Zeit-)Verarbeitung des bereitgestellten Audiosignals kann es ratsam sein, auch die Verzögerungsleitung ("delay line") der FIR-Filtereinrichtung 5 zu leeren, um eine Reproduktion des Signals, welches in der Verzögerungsleitung vor der Unterbrechung der (Echt-Zeit-)Verarbeitung des bereitgestellten Audiosignals gespeichert wurde, zu vermeiden, nachdem die Unterbrechung der (Echt-Zeit-)Verarbeitung des bereitgestellten Audiosignals aufgehoben und die (Echt-Zeit-)Verarbeitung des bereitgestellten Audiosignals wiederaufgenommen wird.

In einem vierten Schritt des Verfahrens erfolgt ein Anwenden einer zweiten Übergangsfunktion (Rückübergangsfunktion), gemäß welcher das Zuführen des Audiosignals über die Signalverarbeitungseinrichtung 7 sukzessive von 100% auf 0% verringert wird und das Zuführen des Audiosignals über die FIR-Filtereinrichtung 5 im Gegenzug sukzessive von 0% auf 100% erhöht wird, wobei das Zuführen des Audiosignals über die FIR-Filtereinrichtung 5 (sodann) auf Grundlage der veränderten FIR-Koeffizienten der FIR-Filtereinrichtung 5 durchgeführt wird. Zu Beginn des vierten Schritts wird das Audiosignal der Audiomischeinrichtung 4 zu 100% über die Signalverarbeitungseinrichtung 7 zugeführt, zum Ende des vierten Schritts wird das Audiosignal der Audiomischeinrichtung 4 (wieder) zu 100% über die FIR-Filtereinrichtung 5 zugeführt. Zwischen Beginn und Ende des vierten Schritts erfolgt eine Zuführung des Audiosignals zu bestimmten, zeitlich variierenden prozentualen Anteilen sowohl über die Signalverarbeitungseinrichtung 7 als auch über die FIR-Filtereinrichtung 5. Die jeweiligen prozentualen Anteile bestimmen sich durch die durch die zweite Übergangsfunktion definierte Maßgabe, dass das Zuführen des Audiosignals zu der Audiomischeinrichtung 4 über die Signalverarbeitungseinrichtung 7 sukzessive von 100% auf 0% verringert und im Gegenzug das Zuführen des Audiosignals zu der Audiomischeinrichtung 4 über die FIR-Filtereinrichtung 5 sukzessive von 0% auf 100% erhöht wird. Als zweite Übergangsfunktion kann eine lineare oder eine nicht-lineare Funktion verwendet werden.

Die Implementierung des Verfahrens erfolgt über die mit geeigneten Morphingalgorithmen ausgestattete hard- und/oder softwaremäßig implementierte Morphingeinrichtung 8 als hard- und/oder softwaremäßigem Bestandteil der Audioausgabeeinrichtung 3.

Im Rahmen des Verfahrens kann die Energie, d. h. insbesondere die Lautstärke, des von der Audiomischeinrichtung 4 während oder nach Durchführung des Morphingvorgangs ausgehenden Audiosignals im Rahmen der Anwendung der ersten Übergangsfunktion von der Energie des von der FIR-Filtereinrichtung 5 ausgehenden Audiosignals auf die Energie des von der Signalverarbeitungseinrichtung 7 ausgehenden Audiosignals verändert werden. Derart ist eine Maßnahme gegeben, welche es ermöglicht, dass der Morphingvorgang für einen Hörer nicht bzw. kaum wahrnehmbar ist.

Im Rahmen des Verfahrens kann die zweite Übergangsfunktion erst nach einer bestimmten Wartezeit bzw. Zeitdauer, d. h. z. B. eine Sekunde, nach Abschluss der Anwendung der ersten Übergangsfunktion durchgeführt werden. Auch derart ist eine Maßnahme gegeben, welche es ermöglicht, dass der Morphingvorgang für einen Hörer nicht bzw. kaum wahrnehmbar ist. Die Wartezeit, nach welcher die zweite Übergangsfunktion angewendet wird, kann auf Grundlage der Länge der FIR-Filtereinrichtung 5 bestimmt und somit auf die durch die Länge der FIR-Filtereinrichtung 5 bzw. der FIR-Koeffizienten gegebene "Konfiguration" der FIR-Filtereinrichtung 5 abgestimmt werden. Die Wartezeit ist typischerweise nicht kürzer als die Länge der FIR-Filtereinrichtung 5.

Wie erwähnt, kann es sich bei der Signalverarbeitungseinrichtung 7 um eine Verstärkungseinrichtung oder eine IIR-Filtereinrichtung handeln. Die Auswahl dahin, ob eine Verstärkungseinrichtung oder eine IIR-Filtereinrichtung als Signalverarbeitungseinrichtung 7 verwendet wird, kann in Abhängigkeit der Bandweite (Frequenzbandweite) des Audiosignals erfolgen. Insbesondere kann bei Audiosignalen mit einer oberhalb einer Grenzbandweite, beispielsweise in einem Bereich zwischen 20 und 100 Hz oder höher, liegenden Bandweite eine Verstärkungseinrichtung als Signalverarbeitungseinrichtung 7 verwendet werden und bei Audiosignalen mit einer unterhalb einer Grenzbandweite, beispielsweise in einem Bereich zwischen 20 und 100 Hz oder höher, liegenden Bandweite eine IIR-Filtereinrichtung als Signalverarbeitungseinrichtung 7 verwendet werden.

Sofern eine Verstärkungseinrichtung als Signalverarbeitungseinrichtung 7 verwendet wird, kann die Leistung, insbesondere der Gain, der Verstärkungseinrichtung auf einen Wert, welcher z. B. (im Wesentlichen) der L2-Norm der Impulsantwort der FIR-Filtereinrichtung 5 entspricht, gesetzt werden, oder die Leistung, insbesondere der Gain, auf einen Wert, welcher einem Mittelwert der Impulsantwort der FIR-Filtereinrichtung 5 vor der Änderung der FIR-Koeffizienten der FIR-Filtereinrichtung 5 oder einem Mittelwert der Impulsantwort der FIR-Filtereinrichtung 5 nach der Änderung der FIR-Koeffizienten entspricht, gesetzt werden. Derart kann der Leistungsbedarf der Verstärkungseinrichtung eingeschränkt und die Effizienz des Verfahrens verbessert werden.

Die im Rahmen des Anwendens der Rückübergangsfunktion, vgl. den vierten Schritt, angewendeten Parameter können in Abhängigkeit von Eigenschaften der zu "morphenden" FIR-Filtereinrichtung erfolgt. Beispielsweise ist es möglich, dass die Antworteigenschaften, insbesondere die Magnitude-Response, der Signalverarbeitungseinrichtung, d. h. z. B. einer IIR-Filtereinrichtung, an die Antworteigenschaften, insbesondere die Magnitude-Response, der FIR-Filtereinrichtung, angepasst bzw. angeglichen werden.

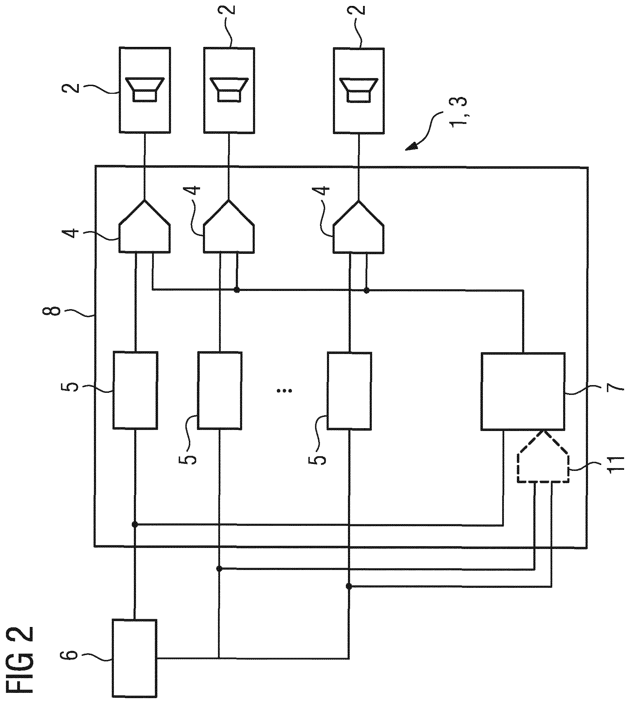

Fig. 2 zeigt eine Prinzipdarstellung einer Vorrichtung 1 zur Durchführung eines Morphingvorgangs gemäß einem weiteren Ausführungsbeispiel der Erfindung.

Anhand von Fig. 2 ist ersichtlich, dass sich das im Zusammenhang mit dem in Fig. 1 gezeigten Ausführungsbeispiel beschriebene Prinzip auch auf eine Vorrichtung 1 mit mehreren parallel geschalteten FIR-Filtereinrichtungen 5 und diesen jeweils zugeordneten Audiomischeinrichtungen 4 anwenden lässt; jede der in Fig. 2 gezeigten FIR-Filtereinrichtungen 5 ist mit einer dieser zugeordneten Audiomischeinrichtung 4 verbunden. Eine Signalverarbeitungseinrichtung 7 ist zu allen FIR-Filtereinrichtungen 5 parallel angeordnet und ebenso mit den den FIR-Filtereinrichtungen 5 zugeordneten Audiomischeinrichtungen 4 verbunden. Strichliert dargestellt, weil optional, ist eine der Signalverarbeitungseinrichtung 7 vorgeschaltete weitere Audiomischeinrichtung 11. Über die weitere Audiomischeinrichtung 11 können während der Durchführung des Verfahrens mit einer bestimmten FIR-Filtereinrichtung 5 den übrigen FIR-Filtereinrichtungen 5 zugeordnete Audiosignale zugemischt werden, sodass ein Hörer den (aktuell durchgeführten) Morphingvorgang nicht bzw. kaum wahrnimmt.

Das beschriebene Verfahren kann sonach auch mit einer (einzigen) Signalverarbeitungseinrichtung 7 und mehreren FIR-Filtereinrichtungen 5 implementiert werden. Die verfahrensgemäß erfolgende Änderung der FIR-Koeffizienten der FIR-Filtereinrichtungen 5 kann zeitgleich oder zeitlich gestaffelt erfolgen.

Die gleichzeitige bzw. simultane Durchführung von Morphingvorgängen mehrerer FIR-Filtereinrichtungen 5 kann unter bestimmten Bedingungen über eine (einzige) Signalverarbeitungseinrichtung 7 erfolgen. In diesem Fall können gewichtete Inputs der FIR-Filtereinrichtungen 5 der der Signalverarbeitungseinrichtung 7 vorgeschalteten weiteren Audiomischeinrichtung 11 und weiter der Signalverarbeitungseinrichtung 7 zugeführt werden. Der Ausgang der Signalverarbeitungseinrichtung 7 ist mit den der Signalverarbeitungseinrichtung 7 nachgeschalteten Audiomischeinrichtungen 4 verbunden, sodass der Ausgang der Signalverarbeitungseinrichtung 7 den Audiomischeinrichtungen 4 zugeführt, d. h. insbesondere auf die nachgeschalteten Audiomischeinrichtungen 4 verteilt, wird.

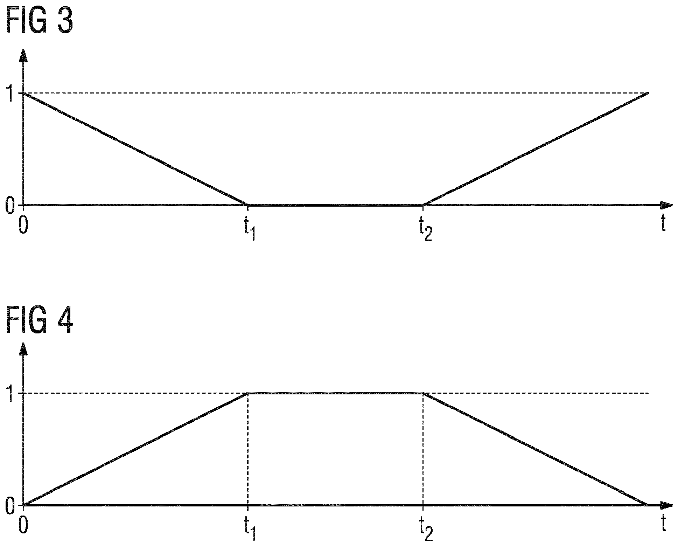

Die Fig. 3, 4 zeigen je eine Prinzipdarstellung von im Rahmen eines Verfahrens gemäß einem Ausführungsbeispiel anwendbarer Übergangsfunktionen. Fig. 3 zeigt ein Beispiel eines Graphen einer ersten Übergangsfunktion, Fig. 4 ein Beispiel eines Graphen einer zweiten Übergangsfunktion.

Die Übergangsfunktionen sind jeweils in einem x-y-Diagramm dargestellt, wobei die x-Achse die Zeitachse und die y-Achse den Grad des Zuführen des Audiosignals zu der Audiomischeinrichtung 4 über die FIR-Filtereinrichtung 5 (Fig. 3) und eine Signalverarbeitungseinrichtung 7 (Fig. 4) anzeigt; ein Wert von "0" zeigt an, dass kein Zuführen des Audiosignals über die FIR-Filtereinrichtung 5 bzw. die Signalverarbeitungseinrichtung 7 erfolgt, ein Wert von "1" zeigt an, dass ein Zuführen des Audiosignal vollständig über die FIR-Filtereinrichtung 5 bzw. die Signalverarbeitungseinrichtung 7 erfolgt.

Anhand der Zeitachse ist ersichtlich, dass das Zuführen des Audiosignals zum Zeitpunkt t₀ ausschließlich über die FIR-Filtereinrichtung 5 erfolgt. Durch Anwenden der ersten Übergangsfunktion fällt der die FIR-Filtereinrichtung 5 betreffende Graph in Fig. 3 ab, wohingegen der die Signalverarbeitungseinrichtung 7 betreffende Graph in Fig. 4 im Verhältnis dazu ansteigt.

Zum Zeitpunkt t₁ erfolgt das Zuführen des Audiosignals ausschließlich über die Signalverarbeitungseinrichtung 7. Es erfolgt im Zeitraum zwischen dem Zeitpunkt t₁ und dem Zeitpunkt t₂ eine in Abhängigkeit der Länge der FIR-Filtereinrichtung 7 gewählte Wartezeit. Die Wartezeit ist typischerweise nicht kürzer als die Länge der FIR-Filtereinrichtung 5.

Zum Zeitpunkt t₂ fällt durch Anwenden der zweiten Übergangsfunktion der die Signalverarbeitungseinrichtung 7 betreffende Graph in Fig. 4 ab, wohingegen der die FIR-Filtereinrichtung 5 betreffende Graph in Fig. 3 im Verhältnis dazu ansteigt.

Für alle Ausführungsbeispiele gilt, dass im Rahmen des Verfahrens eine Mehrzahl an unterschiedlichen Signalverarbeitungseinrichtungen 7 zur Verfügung stehen kann. Die Auswahl, welche Signalverarbeitungseinrichtung 7 im Rahmen des Anwendens der ersten Anhand der Zeitachse ist ersichtlich, dass das Zuführen des Audiosignals zum Zeitpunkt t₀ ausschließlich über die FIR-Filtereinrichtung 5 erfolgt. Durch Anwenden der ersten Übergangsfunktion fällt der die FIR-Filtereinrichtung 5 betreffende Graph in Fig. 3 ab, wohingegen der die Signalverarbeitungseinrichtung 7 betreffende Graph in Fig. 4 im Verhältnis dazu ansteigt.

Zum Zeitpunkt t₁ erfolgt das Zuführen des Audiosignals ausschließlich über die Signalverarbeitungseinrichtung 7. Es erfolgt im Zeitraum zwischen dem Zeitpunkt t₁ und dem Zeitpunkt t₂ eine in Abhängigkeit der Länge der FIR-Filtereinrichtung 7 gewählte Wartezeit. Die Wartezeit ist typischerweise nicht kürzer als die Länge der FIR-Filtereinrichtung 5.

Zum Zeitpunkt t₂ fällt durch Anwenden der zweiten Übergangsfunktion der die Signalverarbeitungseinrichtung 7 betreffende Graph in Fig. 4 ab, wohingegen der die FIR-Filtereinrichtung 5 betreffende Graph in Fig. 3 im Verhältnis dazu ansteigt.

Für alle Ausführungsbeispiele gilt, dass im Rahmen des Verfahrens eine Mehrzahl an unterschiedlichen Signalverarbeitungseinrichtungen 7 zur Verfügung stehen kann. Die Auswahl, welche Signalverarbeitungseinrichtung 7 im Rahmen des Anwendens der ersten und zweiten Übergangsfunktion verwendet wird, kann auf Grundlage wenigstens eines die akustischen Eigenschaften des Audiosignals beschreibenden Audiosignalparameters, insbesondere des Frequenzverlaufs des Audiosignals, erfolgen. Die Ermittlung entsprechenden Audiosignalparameter, welche der Auswahl einer bestimmten Signalverarbeitungseinrichtung 7 zugrunde gelegt wird, kann vermittels geeigneter Audiosignalanalyseparameter erfolgen. Die Auswahl, welche Signalverarbeitungseinrichtung 7 im Rahmen des Anwendens der ersten und zweiten Übergangsfunktion verwendet wird, kann auch auf Grundlage des jeweiligen Energiepegels bzw. psychoakustischen Pegels respektive Amplituden- bzw. Frequenzbereichs der zur Auswahl stehenden Signalverarbeitungseinrichtungen 7 erfolgen; wobei die Auswahl einer Signalverarbeitungseinrichtung 7 mit einem im Vergleich zu der FIR-Filtereinrichtung 5 (möglichst) ähnlichen Pegel respektive Amplituden- bzw. Frequenzbereich zweckmäßig ist.

## Patentansprüche

1. Verfahren zur Durchführung eines Morphingvorgangs, wobei wenigstens ein die Ausgabe eines über eine Audioausgabeeinrichtung (3) in einen Innenraum (10), insbesondere eines Kraftfahrzeugs, ausgegebenen Audiosignals betreffender Ausgabeparameter verändert wird, **gekennzeichnet durch** die folgenden Schritte:
- Zuführen eines von einer Audiosignalquelleinrichtung (6) bereitgestellten Audiosignals zu wenigstens einer Audiomischeinrichtung (4) über wenigstens eine mehrere FIR-Koeffizienten umfassende FIR-Filtereinrichtung (5), wobei das Audiosignal der Audiomischeinrichtung (4) zu 100% über die FIR-Filtereinrichtung (5) zugeführt wird,
- Anwenden einer ersten Übergangsfunktion, gemäß welcher das Zuführen des Audiosignals über die FIR-Filtereinrichtung (5) sukzessive von 100% auf 0% verringert wird und das Zuführen des Audiosignals über eine der FIR-Filtereinrichtung (5) parallel geschaltete Signalverarbeitungseinrichtung (7) im Gegenzug sukzessive von 0% auf 100% erhöht wird,
- Ändern wenigstens eines Teils der FIR-Koeffizienten der FIR-Filtereinrichtung (5) während des Zuführens des Audiosignals über die Signalverarbeitungseinrichtung (7),
- Anwenden einer zweiten Übergangsfunktion, gemäß welcher das Zuführen des Audiosignals über die Signalverarbeitungseinrichtung (7) sukzessive von 100% auf 0% verringert wird und das Zuführen des Audiosignals über die FIR-Filtereinrichtung (5) im Gegenzug sukzessive von 0% auf 100% erhöht wird, wobei das Zuführen des Audiosignals über die FIR-Filtereinrichtung (5) auf Grundlage der veränderten FIR-Koeffizienten der FIR-Filtereinrichtung (5) durchgeführt wird.

2. Verfahren nach Anspruch 1, **dadurch gekennzeichnet, dass** die Energie, d. h. insbesondere die Lautstärke, des von der Audiomischeinrichtung (4) während oder nach Durchführung des Morphingvorgangs ausgehenden Audiosignals im Rahmen der Anwendung der ersten Übergangsfunktion von der Energie des von der FIR-Filtereinrichtung (5) ausgehenden Audiosignals auf die Energie des von der Signalverarbeitungseinrichtung (7) ausgehenden Audiosignals verändert wird.

3. Verfahren nach Anspruch 1 oder 2, **dadurch gekennzeichnet, dass** als erste und/oder zweite Übergangsfunktion eine lineare oder eine nicht-lineare Funktion verwendet wird.

4. Verfahren nach einem der vorhergehenden Ansprüche, **dadurch gekennzeichnet, dass** die zweite Übergangsfunktion erst nach einer bestimmten Wartezeit nach Abschluss der Anwendung der ersten Übergangsfunktion durchgeführt wird.

5. Verfahren nach Anspruch 4, **dadurch gekennzeichnet, dass** die Wartezeit, nach welcher die zweite Übergangsfunktion angewendet wird, auf Grundlage der Länge der FIR-Filtereinrichtung (5) bestimmt wird.

6. Verfahren nach einem der vorhergehenden Ansprüche, **dadurch gekennzeichnet, dass** das Ändern des wenigstens einen Teils der FIR-Koeffizienten durch Laden, insbesondere Neuladen, von FIR-Koeffizienten aus einer Speichereinrichtung, insbesondere aus einer nicht-flüchtigen Datenspeichereinrichtung, oder durch Wechseln der FIR-Filterkoeffizienten durch zuvor in einer Speichereinrichtung, insbesondere einer nicht-flüchtigen Datenspeichereinrichtung, gespeicherte FIR-Filterkoeffizienten erfolgt.

7. Verfahren nach einem der vorhergehenden Ansprüche, **dadurch gekennzeichnet, dass** eine Mehrzahl an unterschiedlichen Signalverarbeitungseinrichtungen (7) zur Verfügung steht, wobei die Auswahl, welche Signalverarbeitungseinrichtung (7) im Rahmen des Anwendens der ersten und zweiten Übergangsfunktion verwendet wird, auf Grundlage wenigstens eines die akustischen Eigenschaften des Audiosignals beschreibenden Audiosignalparameters, insbesondere des Frequenzverlaufs, erfolgt.

8. Verfahren nach einem der vorhergehenden Ansprüche, **dadurch gekennzeichnet, dass** als Signalverarbeitungseinrichtung (7) eine Einrichtung verwendet wird, welche weniger Rechenleistung und/oder weniger Speicher als die FIR-Filtereinrichtung (5) aufweist, verwendet wird.

9. Verfahren nach einem der vorhergehenden Ansprüche, **dadurch gekennzeichnet, dass** als Signalverarbeitungseinrichtung (7) eine Verstärkungseinrichtung oder eine IIR-Filtereinrichtung verwendet wird.

10. Verfahren nach Anspruch 9, **dadurch gekennzeichnet, dass** bei Audiosignalen mit einer oberhalb einer Grenzbandweite, insbesondere in einem Bereich zwischen 20 und 100 Hz, liegenden Bandweite eine Verstärkungseinrichtung als Signalverarbeitungseinrichtung (7) verwendet wird und bei Audiosignalen mit einer unterhalb einer Grenzbandweite, insbesondere in einem Bereich zwischen 20 und 100 Hz, liegenden Bandweite eine IIR-Filtereinrichtung als Signalverarbeitungseinrichtung (7) verwendet wird.

11. Verfahren nach Anspruch 9 oder 10, **dadurch gekennzeichnet, dass**, sofern eine Verstärkungseinrichtung als Signalverarbeitungseinrichtung (7) verwendet wird, die Leistung, insbesondere der Gain, der Verstärkungseinrichtung auf einen Wert, welcher der L2-Norm der Impulsantwort der FIR-Filtereinrichtung (5) entspricht, gesetzt wird, oder die Leistung, insbesondere der Gain, auf einen Wert, welcher einem Mittelwert der Impulsantwort der FIR-Filtereinrichtung (5) vor der Änderung der FIR-Koeffizienten der FIR-Filtereinrichtung (5) entspricht oder einem Mittelwert der Impulsantwort der FIR-Filtereinrichtung (5) nach der Änderung der FIR-Koeffizienten entspricht, gesetzt wird.

12. Vorrichtung (1) zur Durchführung eines Morphingvorgangs, **gekennzeichnet durch:**
- wenigstens eine FIR-Filtereinrichtung (5), wenigstens eine parallel zu dieser geschaltete Signalverarbeitungseinrichtung (7), insbesondere eine Verstärkereinrichtung oder eine IIR-Filtereinrichtung,
- wenigstens eine Audiomischeinrichtung (4), welche mit jeweiligen Ausgängen der FIR-Filtereinrichtung (5) und der Signalverarbeitungseinrichtung (7) verbunden ist, sowie
- eine Morphingeinrichtung (8), welche zur Durchführung eines Morphingvorgangs gemäß dem Verfahren nach einem der vorhergehenden Ansprüche eingerichtet ist.

13. Kraftfahrzeug, umfassend wenigstens eine Vorrichtung (1) nach Anspruch 12.

## Claims

1. Method for carrying out a morphing process, wherein at least one output parameter relating to the output of an audio signal output via an audio output device (3) into an interior (10), in particular of a motor vehicle, is changed, **characterised by** the following steps:
- supplying an audio signal, provided by an audio signal source device (6), to at least one audio mixing device (4) via at least one FIR filter means (5) comprising a plurality of FIR coefficients, wherein 100% of the audio signal of the audio mixing device (4) is supplied via the FIR filter means (5),
- applying a first transition function, according to which the supplying of the audio signal via the FIR filter means (5) is reduced successively from 100% to 0% and, conversely, the supplying of the audio signal via a signal processing device (7) connected in parallel with the FIR filter means (5) is increased successively from 0% to 100%,
- changing at least one portion of the FIR coefficients of the FIR filter means (5) during the supplying of the audio signal via the signal processing device (7),
- applying a second transition function, according to which the supplying of the audio signal via the signal processing device (7) is reduced successively from 100% to 0% and, conversely, the supplying of the audio signal via the FIR filter means (5) is increased successively from 0% to 100%, wherein the supplying of the audio signal via the FIR filter means (5) is carried out on the basis of the changed FIR coefficients of the FIR filter means (5).

2. Method according to claim 1, **characterised in that** the energy, i.e. in particular the volume, of the audio signal emanating by the audio mixing device (4) during or after performance of the morphing process is changed, within the context of the application of the first transition function, from the energy of the audio signal emanating from the FIR filer means (5) to the energy of the audio signal emanating from the signal processing device (7).

3. Method according to either claim 1 or claim 2, **characterised in that** a linear or a non-linear function is used as the first and/or second transition function.

4. Method according to any of the preceding claims, **characterised in that** the second transition function is carried out only after a specified delay time following conclusion of the application of the first transition function.

5. Method according to claim 4, **characterised in that** the delay time after which the second transition function is applied is determined on the basis of the length of the FIR filter means (5).

6. Method according to any of the preceding claims, **characterised in that** the changing of the at least one portion of the FIR coefficients take place by loading, in particular re-loading, FIR coefficients from a storage device, in particular from a non-volatile data storage device, or by switching the FIR filter coefficients with FIR filter coefficients previously stored in a storage device, in particular a non-volatile data storage device.

7. Method according to any of the preceding claims, **characterised in that** a plurality of different signal processing devices (7) is available, wherein the selection of which signal processing device (7) is used within the context of the application of the first and second transition function is made on the basis of at least one audio signal parameter describing the acoustic properties of the audio signal, in particular the frequency response.

8. Method according to any of the preceding claims, **characterised in that** a device which uses less computing power and/or less memory than the FIR filter means (5) is used as the signal processing device (7).

9. Method according to any of the preceding claims, **characterised in that** an amplifier device or an IIR filter means is used as a signal processing device (7).

10. Method according to claim 9, **characterised in that,** in the case of audio signals having a bandwidth above a limit bandwidth, in particular in a range between 20 and 100 Hz, an amplifier device is used as the signal processing device (7), and in the case of audio signals having a bandwidth below a limit bandwidth, in particular in a range between 20 and 100 Hz, an IRR filter means is used as the signal processing device (7).

11. Method according to either claim 9 or claim 10, **characterised in that,** if an amplifier device is used as the signal processing device (7), the power, in particular the gain, of the amplifier device is set to a value which corresponds to the L2 norm of the impulse response of the FIR filter means (5), or the power, in particular the gain, is set to a value which corresponds to an average value of the impulse response of the FIR filter means (5) before the change of the FIR coefficients of the FIR filter means (5), or an average value of the impulse response of the FIR filter means (5) after the change of the FIR coefficients.

12. Device (1) for carrying out a morphing process, **characterised by:**
- at least one FIR filter means (5), at least one signal processing device (7), in particular an amplifier device or an IIR filter means, connected in parallel with said FIR filter means,
- at least one audio mixing device (4) which is connected to respective outputs of the FIR filter means (5) and of the signal processing device (7), and
- a morphing device (8) which is designed for carrying out a morphing process according to the method according to any of the preceding claims.

13. Motor vehicle, comprising at least one device (1) according to claim 12.

## Revendications

1. Procédé de mise en oeuvre d'une opération de morphose, dans lequel est modifié au moins un paramètre de sortie concernant la sortie d'un signal audio délivré en sortie par l'intermédiaire d'un système de sortie audio (3) dans un espace intérieur (10), en particulier d'un véhicule à moteur, **caractérisé par** les étapes suivantes :
- l'amenée d'un signal audio fourni par un système source de signaux audio (6) à au moins un système de mixage audio (4) par l'intermédiaire d'au moins un système de filtrage FIR (5) comprenant plusieurs coefficients FIR, dans lequel le signal audio du système de mixage audio (4) est amené à 100 % par l'intermédiaire du système de filtrage FIR (5),
- l'application d'une première fonction de transfert, selon laquelle l'amenée du signal audio est réduite par l'intermédiaire du système de filtrage FIR (5) successivement de 100 % à 0 % et l'amenée du signal audio est augmentée par l'intermédiaire d'un système de traitement de signaux (7) branché en parallèle au système de filtrage FIR (5) en contrepartie successivement de 0 % à 100 %,
- la modification d'au moins une partie des coefficients FIR du système de filtrage FIR (5) pendant l'amenée du signal audio par l'intermédiaire du système de traitement de signaux (7),
- l'application d'une deuxième fonction de transfert, selon laquelle l'amenée du signal audio est réduite par l'intermédiaire du système de traitement de signaux (7) successivement de 100 % à 0 % et l'amenée du signal audio est augmentée par l'intermédiaire du système de filtre FIR (5) en contrepartie successivement de 0 % à 100 %, dans lequel l'amenée du signal audio est mise en oeuvre par l'intermédiaire du système de filtrage FIR (5) sur la base des coefficients FIR modifiés du système de filtrage FIR (5).

2. Procédé selon la revendication 1, **caractérisé en ce que** l'énergie, en d'autres termes l'intensité, du signal audio partant du système de mixage audio (4) pendant ou après la mise en oeuvre de l'opération de morphose est modifiée dans le cadre de l'application de la première fonction de transfert de l'énergie du signal audio partant du système de filtrage FIR (5) à l'énergie du signal audio partant du système de traitement de signaux (7).

3. Procédé selon la revendication 1 ou 2, **caractérisé en ce qu'**une fonction linéaire ou une fonction non linéaire sont utilisées en tant que première et/ou deuxième fonction de transfert.

4. Procédé selon l'une quelconque des revendications précédentes, **caractérisé en ce que** la deuxième fonction de transfert est mise en oeuvre seulement après un temps d'attente défini à l'issue de l'application de la première fonction de transfert.

5. Procédé selon la revendication 4, **caractérisé en ce que** le temps d'attente, après lequel la deuxième fonction de transfert est appliquée, est défini sur la base de la longueur du système de filtrage FIR (5).

6. Procédé selon l'une quelconque des revendications précédentes, **caractérisé en ce que** la modification de l'au moins une partie des coefficients FIR est effectuée par chargement, en particulier rechargement, de coefficients FIR depuis un système de mémoire, en particulier depuis un système de mémoire de données non volatile, ou par remplacement des coefficients de filtrage FIR par des coefficients de filtrage FIR mémorisés antérieurement dans un système de mémoire, en particulier un système de mémoire de données non volatile.

7. Procédé selon l'une quelconque des revendications précédentes, **caractérisé en ce qu'**une multitude de différents systèmes de traitement de signaux (7) sont disponibles, lequel système de traitement de signaux (7) étant utilisé dans le cadre de l'application de la première et de la deuxième fonction de transfert, dans lequel la sélection est effectuée sur la base d'au moins un paramètre de signal audio décrivant les propriétés acoustiques du signal audio, en particulier de la variation de fréquence.

8. Procédé selon l'une quelconque des revendications précédentes, **caractérisé en ce qu'**est utilisé en tant que système de traitement de signaux (7) un système, lequel présente moins de puissance de calcul et/ou moins de mémoire que le système de filtrage FIR (5).

9. Procédé selon l'une quelconque des revendications précédentes, **caractérisé en ce qu'**un système d'amplification ou un système de filtrage FIR est utilisé en tant que système de traitement de signaux (7).

10. Procédé selon la revendication 9, **caractérisé en ce que** pour des signaux audio avec une largeur de bande située au-dessus d'une largeur de bande limite, en particulier dans une plage entre 20 et 100 Hz, un système d'amplification est utilisé en tant que système de traitement de signaux (7) et pour des signaux audio avec une largeur de bande située en dessous d'une largeur de bande limite, en particulier dans une plage entre 20 et 100 Hz, un système de filtrage FIR est utilisé en tant que système de traitement de signaux (7).

11. Procédé selon la revendication 9 ou 10, **caractérisé en ce que,** si un système d'amplification est utilisé en tant que système de traitement de signaux (7), la puissance, en particulier le gain, du système d'amplification est réglée sur une valeur, laquelle correspond à la norme L2 de la réponse en impulsion du système de filtrage FIR (5), ou la puissance, en particulier le gain, est réglée sur une valeur, laquelle correspond à une valeur moyenne de la réponse en impulsion du système de filtrage FIR (5) avant la modification des coefficients FIR du système de filtrage FIR (5) ou correspond à une valeur moyenne de la réponse en impulsion du système de filtrage FIR (5) après la modification des coefficients FIR.

12. Dispositif (1) pour la mise en oeuvre d'une opération de morphose, **caractérisé par** :
- au moins un système de filtrage FIR (5), au moins un système de traitement de signaux (7) monté en parallèle par rapport à celui-ci, en particulier un système d'amplification ou un système de filtrage FIR,
- au moins un système de mixage audio (4), lequel est relié à des sorties respectives du système de filtrage FIR (5) et du système de traitement de signaux (7), ainsi
- qu'un système de morphose (8), lequel est mis au point pour la mise en oeuvre d'une opération de morphose selon le procédé selon l'une quelconque des revendications précédentes.

13. Véhicule à moteur, comprenant au moins un dispositif (1) selon la revendication 12.
